Europäisches Patentamt

European Patent Office

Office européen des brevets

(11) Publication number: **0 116 243**
**B1**

# EUROPEAN PATENT SPECIFICATION

(45) Date of publication of patent specification: **18.03.87**

(21) Application number: **83402388.9**

(22) Date of filing: **12.12.83**

(51) Int. Cl.⁴: **H 03 K 5/24,** G 11 C 7/00

(54) Comparator.

(30) Priority: **24.12.82 JP 225825/82**

(43) Date of publication of application:
**22.08.84 Bulletin 84/34**

(45) Publication of the grant of the patent:
**18.03.87 Bulletin 87/12**

(84) Designated Contracting States:
**DE FR GB**

(56) References cited:
**EP-A-0 057 111**
**GB-A-2 084 828**
**US-A-4 192 014**
**US-A-4 327 424**
**US-A-4 358 690**
**US-A-4 388 702**

**Patent Abstracts of Japan vol. 4, no. 170, 22
November 1980 & JP-A-55-117327**
**Patent Abstracts of Japan vol. 5, no. 3, 10
January 1981 & JP-A-55-134535**

**ELECTRONICS, vol. 53, no. 22, 9 October 1980,
New York J.G. POSA "Four-state cell doubles
ROM bit capacity", page 39**

(73) Proprietor: **FUJITSU LIMITED**
**1015, Kamikodanaka Nakahara-ku
Kawasaki-shi Kanagawa 211 (JP)**

(72) Inventor: **Takemae Yoshihiro
8-13-24-303, Akasaka Minato-ku
Tokyo 107 (JP)**
Inventor: **Suzuki, Yasuo
11-16, Shiratoridai Midori-ku
Yokohama-shi Kanagawa 227 (JP)**

(74) Representative: **Descourtieux, Philippe et al
CABINET BEAU de LOMENIE 55 rue
d'Amsterdam
F-75008 Paris (FR)**

## Description

### Background of the invention
### Field of the invention

The present invention relates to a comparator by which it can be determined whether or not a certain voltage is in a predetermined range with respect to a reference voltage.

### Description of the prior art

For the purpose of increasing the integration density, mask read-only memory cells having multi-values, for example, four values, recently have frequently been used. In the case of a cell having four values, the four values correspond to the width of the transistor, and the mid value of the width is used as the value of the reference cell. The value of the reference cell is read out, and the readout value is coded into binary information. In such a cell having four values, the deviation of the width of the transistor of the reference cell should be small because the width of the transistor is originally small. Therefore, detection of the value of the reference cell becomes very difficult because the flip-flip circuit which is conventionally used cannot be used to detect this value.

A flip-flop circuit can be used to determine whether or not an input voltage is larger or smaller than the reference voltage. However, a flip-flop circuit cannot be used to determine whether or not the input voltage is in the predetermined range with respect to the reference voltage or in which direction the input voltage is shifted from the predetermined range. In such a case, a window comparator comprising two comparators is used. However, a window comparator requires two kinds of reference voltages and the circuit of the window comparator is complicated, thereby rendering the comparator unsuitable for forming an integrated circuit.

### Objects and summary of the invention

An object of the present invention is to form a comparator by which it can be determined whether or not a certain voltage is in a predetermined range with respect to a reference voltage.

Another object of the present invention is to provide a comparator which can be used to suitably determine the multi-values of a read-only memory cell.

According to the present invention, this object can be achieved with a comparator circuit comprising a first flip-flop circuit having a first terminal and a second terminal; a second flip-flop circuit having a third terminal and a fourth terminal, a first switching circuit and a second switching circuit which respectively connect said first terminal and third terminal to a source providing an input voltage to be compared to a reference voltage; a third switching circuit and a fourth switching circuit which respectively connect said second terminal and fourth terminal to a source of said reference voltage; and a fifth switching circuit which is commonly connected to said first flip-flop circuit and second flip-flop circuit for activating said first and second flip-flop circuits; the first and second flip-flop circuits having different threshold voltages to operate asymmetrically with the first flip-flop circuit inverting its state when the input voltage becomes larger than the reference voltage by a first predetermined voltage difference, $\Delta V_1$, and the second flip-flop circuit inverting its state when the input voltage becomes smaller than the reference voltage by a second predetermined voltage difference $\Delta V_2$, whereby whether or not the input voltage is in the range of

$$V_R - \Delta V_2 \text{ to } V_R + \Delta V_1,$$

or is higher than $V_R + \Delta V_1$ or is lower than $V_R - \Delta V_2$ can be determined as a function of the state of the flip-flop circuits.

Further, features and advantages of the present invention will be apparent from the ensuing description, with reference to the accompanying drawings, to which, however, the scope of the invention is no way limited.

### Brief description of the drawings

Figure 1 is a circuit diagram of one embodiment of the comparator according to the present invention.

Figures 2A to 2D are diagrams illustrating the operation of the comparator in Fig. 1.

Figure 3 is a block diagram illustrating how the present invention is used for determining the four values of the read-only memory cell.

Figure 4 is a circuit diagram of another embodiment of the comparator according to the present invention.

Figures 5A to 5D are diagrams illustrating the operation of the comparator shown in Fig. 4.

### Description of the preferred embodiments

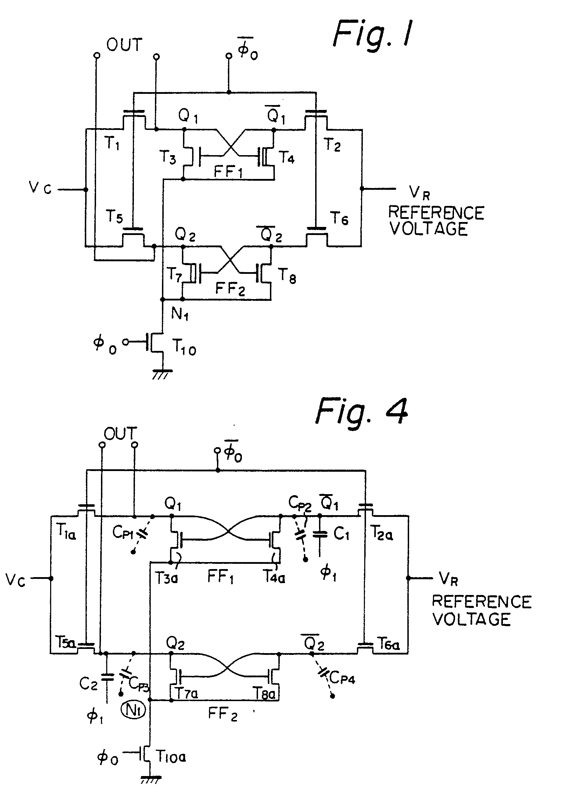

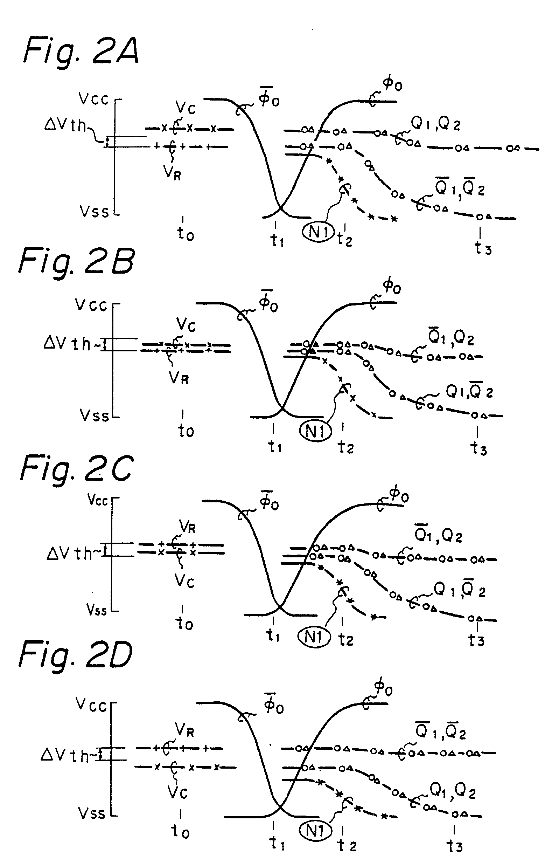

Figure 1 illustrates one embodiment of the present invention, and Figs. 2A to 2D are diagrams illustrating the function of the present invention.

In Fig. 1, the transistors $T_1$, $T_2$, $T_5$, and $T_6$ are controlled by a phase clock pulse $\phi_0$ and are used after precharging the nodes $Q_1$, $\overline{Q}_1$, $Q_2$, and $\overline{Q}_2$ to the voltage $V_C$ and the reference voltage $V_R$, respectively, to separate the input side and the reference voltage side from the comparator. The transistors $T_3$ and $T_4$ form a first flip-flop circuit $FF_1$, and the transistors $T_7$ and $T_8$ form a second flip-flop circuit $FF_2$. In the transistors $T_3$, $T_4$ and $T_7$, $T_8$, a difference of several hundred millivolts ($\Delta V_{th}$) of the threshold value $V_{th}$ is created. That is, the threshold value $V_{th}$ of the transistors $T_4$, $T_7$ is set several hundred millivolts higher than that of the transistors $T_3$, $T_8$. In such a construction, when the voltage $V_C$ is in the range of several hundred millivolts with respect to the reference voltage $V_R$, the nodes $Q_1$, $Q_2$ (or $\overline{Q}_1$, $\overline{Q}_2$) of the first flip-flop $FF_1$ and of the second flip-flop $FF_2$ have reverse

relationships. When the voltage $V_C$ is several millivolts higher than the voltage $V_R$, the nodes $Q_1$ and $Q_2$ both become a high level, and when the voltage $V_C$ is several millivolts lower than the voltage $V_R$, the nodes $Q_1$ and $Q_2$ both become a low level. That is, when $\overline{\phi_0}$ is placed at a high level and $\phi_0$ is placed at a low level, the nodes $Q_1$, $\overline{Q_1}$, $Q_2$, and $\overline{Q_2}$ are precharged. When $\overline{\phi_0}$ is placed at a low level and $\phi_0$ is placed at a high level, the transistors $T_1$, $T_2$, $T_5$, and $T_6$ are placed in an off state, the transistor $T_{10}$ is placed in an on state, and the flip-flops $FF_1$ and $FF_2$ are activated so that the comparator operation is commenced.

This operation is shown in Figs. 2A, 2B, 2C, and 2D. Figure 2A illustrates the case when the voltage $V_C$ is

$$V_C > V_R + \Delta V_{th}.$$

In this case, the transistor $T_4$ turns on and the transistor $T_3$ turns off so that the node $Q_1$ becomes a high level and the node $\overline{Q_1}$ becomes a low level. Further, the transistor $T_8$ turns on and the transistor $T_7$ turns off so that the node $Q_2$ becomes a high level and the node $\overline{Q_2}$ becomes a low level.

Figure 2B illustrates the case when

$$V_R + \Delta V_{th} > V_C > V_R.$$

In this case, the transistor $T_3$ turns on, the transistor $T_4$ turns off, the transistor $T_7$ turns off, and the transistor $T_8$ turns on so that the nodes $Q_1$, $\overline{Q_2}$ become a low level and the nodes $\overline{Q_1}$, $Q_2$ becomes a high level.

Figure 2C illustrates the case where

$$V_R > V_C > V_R - \Delta V_{th}.$$

In this case, the nodes $Q_1$, $\overline{Q_2}$ become a low level and the nodes $Q_2$, $\overline{Q_1}$ become a high level.

Figure 2D illustrates the case when

$$V_R - \Delta V_{th} > V_C.$$

In this case, the nodes $\overline{Q_1}$, $\overline{Q_2}$ become a high level and the nodes $Q_2$, $Q_1$ become a low level.

The cases shown in Figs. 2A, 2B, 2C, and 2D are shown in the Table.

TABLE

| | | NODES | |
| --- | --- | --- | --- |
| | | $Q_1$ | $Q_2$ |
| $V_C > V_R + \Delta V_{th}$ | Fig. 2A | "H" | "H" |
| $V_R + \Delta V_{th} > V_C$ $> V_R - \Delta V_{th}$ | Fig. 2B Fig. 2C | "L" | "H" |
| $V_R - \Delta V_{th} > V_C$ | Fig. 2D | "L" | "L" |

As is shown in the Table, when the voltage $V_C$ is

in the range of several hundred millivolts with respect to the reference voltage $V_R$, the node $Q_1$ becomes a low level but the node $Q_2$ becomes a high level. Therefore, if the levels of the nodes $Q_1$, $Q_2$ (or $\overline{Q_1}$, $\overline{Q_2}$) are monitored, whether or not the voltage $V_C$ is in the range of several hundred millivolts with respect to the reference voltage $V_R$ or is higher or lower than this range can be determined. This range can be freely determined by changing the difference $\Delta V_{th}$ between the transistors $T_3$, $T_4$ and the transistors $T_7$, $T_8$. Further, the difference $\Delta V_{th}$ can be easily changed by changing the threshold value of the transistors in accordance with the ion implantation.

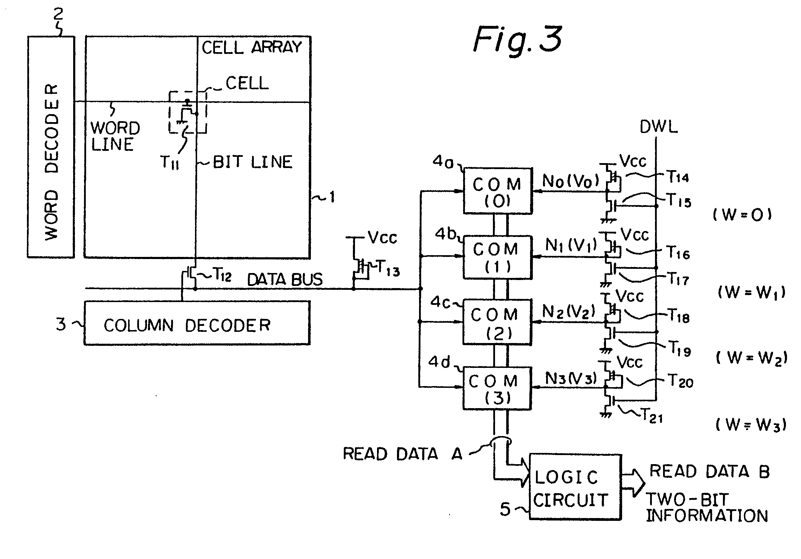

Figure 3 illustrates the application of the comparator shown in Fig. 1. In Fig. 3, a cell array 1 includes a transistor $T_{11}$, having four values, positioned close to a word line and a bit line. The word line and the bit line are selected by a word decoder 2 and a column decoder 3. The selected value of the transistor $T_{11}$ is supplied via a transistor $T_{12}$ to a transistor $T_{13}$ which is used as a level generator which outputs four levels. The output of the transistor $T_{13}$ is supplied to comparators 4a, 4b, 4c, and 4d which correspond to the comparator shown in Fig. 1. The transistors $T_{14}$, $T_{15}$, $T_{16}$, $T_{17}$, $T_{18}$, $T_{19}$, $T_{20}$, and $T_{21}$ are used for supplying four reference voltages to the comparators 4a, 4b, 4c, and 4d. The transistors $T_{15}$, $T_{17}$, $T_{19}$, and $T_{21}$ are used as dummy cells, and the width of the transistors corresponds to the four values of the transistors in the read-out memory cell. The data of only one of the comparators 4a to 4d corresponds to the output of the transistor $T_{13}$ is output as read data A, and this read data is converted to two-bit information in a logic circuit 5.

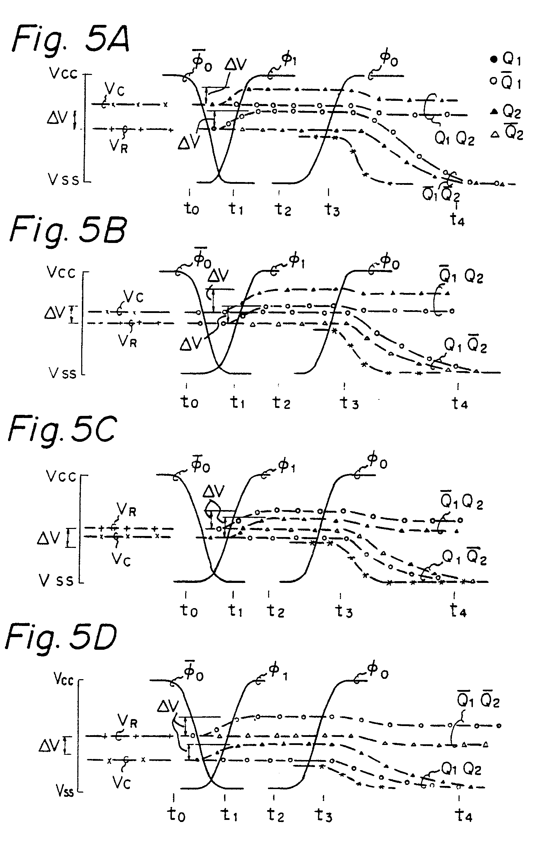

Figure 4 is a circuit diagram of another embodiment of the present invention. In the embodiment of Fig. 4, the transistors $T_{3a}$, $T_{4a}$ and $T_{7a}$, $T_{8a}$ have the same threshold voltage $V_{th}$, and a difference of voltage $\Delta V$ is created between the transistors 3a and 4a and between the transistors $T_{7a}$ and $T_{8a}$. In Fig. 4, $C_{P1}$, $C_{P2}$, $C_{P3}$, and $C_{P4}$ are stray capacitances in the node $Q_1$, $\overline{Q_1}$, $Q_2$ and $\overline{Q_2}$, respectively, and the value of the stray capacitances is substantially the same because the layout of the flip-flop circuit is usually symmetrical. Therefore, as is shown in Fig. 4, one terminal of the capacitors $C_1$ and $C_2$ is added to the collectors of the transistor $T_{4a}$ and the transistor $T_{7a}$ and another terminal of the capacitors $C_1$ and $C_2$ receives the phase clock pulse input $\phi_1$.

In the circuit shown in Fig. 4, at first, the phase clock pulse $\overline{\phi_0}$ is placed at $V_{SS}$, the phase clock pulse $\phi_1$ is changed from $V_{SS}$ to $V_{CC}$, and the nodes $\overline{Q_1}$ and $Q_2$ are placed at a high potential level. Thus, a difference potential $\Delta V$ is created between $Q_1$, and $\overline{Q_1}$ and $Q_2$ and $\overline{Q_2}$. This is the same effect as the different threshold levels in the transistors shown in Fig. 1. Next, the phase clock pulse $\phi_0$ is applied so as to operate the flip-flop circuits $FF_1$, $FF_2$. The raised voltage $\Delta V$ is given as the value

$$\Delta V = V_{cc} \times \frac{C_1}{C_{P2}+C_1}$$

and the value of the capacitance $C_1$ can be suitably selected for the purpose of determining the value of $\Delta V$.

Timing charts showing the operation of the circuit shown in Fig. 4 are shown in Figs. 5A, 5B, 5C, and 5D.

Figure 5A shows the case when

$$V_C > V_R + \Delta V.$$

At the time $t_0$, the value of $\overline{\phi_0}$ is placed at $V_{SS}$, and the potentials of $V_C$ and $V_R$ are stored in the nodes $Q_1$, $\overline{Q}_1$ and $Q_2$, $\overline{Q}_2$. Next, the phase clock pulse $\phi_1$ is changed from $V_{SS}$ to $V_{CC}$, and the potentials of the nodes $\overline{Q}_1$, $Q_2$ are raised to the value of $\Delta V$. Therefore, at the time $t_2$, as originally

$$V_C > V_R + \Delta V,$$

even if the potential of $\overline{Q}_1$ is raised to $\Delta V$, $VQ_1 > V\overline{Q}_1$. On the other hand, as the potential of $Q_2$ is raised to $\Delta V$, $VQ_2 > V\overline{Q}_2$. Next, the flip-flop circuits $FF_1$ and $FF_2$ are operated at the time $t_3$.

Figure 5B shows the case when

$$V_R + \Delta V > V_C > V_R.$$

In this case, at the time $t_2$, the potential of the node $\overline{Q}_1$ is raised to $\Delta V$. Therefore, the values of the potentials of $Q_1$, $\overline{Q}_1$ are inverted so that they become $V\overline{Q}_1 > VQ_1$. However, the values of the potentials of $Q_2$, $\overline{Q}_2$ remain $VQ_2 > V\overline{Q}_2$.

Figure 5C shows the case when

$$V_R > V_C > V_R - \Delta V.$$

In this case, at the time $t_2$, the values of the potentials of $Q_1$, $\overline{Q}_1$ remains $V\overline{Q}_1 > VQ_1$. However, the potential of the node $Q_2$ is raised to $\Delta V$ by the phase clock pulse $\phi_1$, and the relationship of the potentials of $Q_2$ and $\overline{Q}_2$ is inverted from $V\overline{Q}_2 > VQ_2$ to $VQ_2 > V\overline{Q}_2$.

Figure 5D shows the case when

$$V_C < V_R - \Delta V.$$

In this case, if the potentials of the nodes $\overline{Q}_1$, $Q_2$ are raised, at the time $t_2$, the relationships $V\overline{Q}_1 > VQ_1$ and $V\overline{Q}_2 > VQ_2$ do not change.

As is explained in detail above, in accordance with the present invention, whether or not $V_C$ is in the range of several hundred millivolts with respect to the reference voltage or is higher or lower than this range can be precisely determined by using this simple circuit. Further, this range can be freely set by changing the threshold voltages of the transistors used in the flip-flop circuit.

## Claims

1. A comparator circuit comprising a first flip-flop circuit ($FF_1$) having a first terminal ($Q_1$) and a second terminal ($\overline{Q}_1$); a second flip-flop circuit ($FF_2$) having a third terminal ($Q_2$) and a fourth terminal ($\overline{Q}_2$); a first switching circuit ($T_1$; $T_{1a}$) and a second switching circuit ($T_5$; $T_{5a}$) which respectively connect said first terminal and third terminal to a source providing an input voltage ($V_C$) to be compared to a reference voltage ($V_R$); a third switching circuit ($T_2$; $T_{2a}$) and a fourth switching circuit ($T_6$; $T_{6a}$) which respectively connect said second terminal and fourth terminal to a source of said reference voltage ($V_R$); and a fifth switching circuit ($T_{10}$; $T_{10a}$) which is commonly connected to said first flip-flop circuit and said second flip-flop circuit for activating said first and second flip-flop circuits; the first and second flip-flop circuits having different threshold voltages to operate asymmetrically with the first flip-flop circuit inverting its state when the input voltage becomes larger than the reference voltage by a first predetermined voltage difference $\Delta V_1$, and the second flip-flop circuit inverting its state when the input voltage becomes smaller than the reference voltage by a second predetermined voltage difference $\Delta V_2$, whereby whether or not the input voltage ($V_C$) is in the range of $V_R - \Delta V_2$ to $V_R + \Delta V_1$, or is higher than $V_R + \Delta V_1$ or is lower than $V_R - \Delta V_2$ can be determined as a function of the state of the flip-flop circuits.

2. A comparator according to Claim 1, wherein said first flip-flop comprises a first transistor ($T_3$) having a gate which is connected to said second terminal ($\overline{Q}_1$) and a second transistor ($T_4$) having a gate which is connected to said first terminal ($Q_1$), said second flip-flop circuit comprising a third transistor ($T_7$) having a gate which is connected to said fourth terminal ($\overline{Q}_2$) and a fourth transistor ($T_8$) having a gate which is connected to said third terminal ($Q_2$), and the threshold values of said first transistor ($T_3$) and said fourth transistor ($T_8$) are set to be different from those of said second transistor ($T_4$) and said third transistor ($T_7$).

3. A comparator according to Claim 1, wherein said first flip-flop circuit comprises a first transistor ($T_{3a}$) having a gate which is connected to said second terminal ($\overline{Q}_1$) and a second transistor ($T_{4a}$) having a gate which is connected to said first terminal ($Q_1$); said second flip-flop circuit comprising a third transistor ($T_{7a}$) having a gate which is connected to said fourth terminal ($\overline{Q}_2$ and a fourth transistor ($T_{8a}$) having a gate which is connected to said third terminal ($Q_2$); and a first and a second capacitor ($C_1$, $C_2$) are asymmetrically connected to the first and second flip-flops circuits; the first capacitor ($C_1$) being connected between a terminal receiving a phase clock pulse ($\phi_1$) and one terminal ($\overline{Q}_1$) of the first flip-flop circuit while the second capacitor ($C_2$) is connected between a terminal receiving said phase clock pulse ($\phi_1$) and the opposite terminal ($Q_2$) of the second flip-flop circuit.

**Patentansprüche**

1. Komparatorschaltung mit: einer ersten Flipflop-Schaltung (FF₁), die einen ersten Anschluß (Q₁) und einen zweiten Anschluß ($\overline{Q_1}$) hat; einer zweiten Flipflop-Schaltung (FF₂), die einen dritten Anschluß (Q₂) und einen vierten Anschluß ($\overline{Q_2}$) hat; einem ersten Schalterkreis (T₁; T₁ₐ) und einem zweiten Schalterkreis (T₅; T₅ₐ), die jeweils den ersten Anschluß und dritten Anschluß mit einer Quelle verbinden, die eine Eingangsspannung (V_C) liefert, die mit einer Referenzspannung (V_R) verglichen werden soll; einem dritten Schalterkreis (T₂; T₂ₐ) und einem vierten Schalterkreis (T₆; T₆ₐ), die jeweils den genannten zweiten Anschluß und vierten Anschluß mit einer Quelle der genannten Referenzspannung (V_R) verbinden; und einem fünften Schalterkreis (T₁₀; T₁₀ₐ), der gemeinsam mit der genannten ersten Flipflop-Schaltung und der genannten zweiten Flipflop-Schaltung verbunden ist, um die genannten ersten und zweiten Flipflop-Schaltungen zu aktivieren, wobei die ersten und zweiten Flipflop-Schaltungen verschiedene Schwellwertspannungen haben, um asymmetrisch zu arbeiten, wobei die erste Flipflop-Schaltung ihren Zustand invertiert, wenn die Eingangsspannung um einen vorbestimmte Spannungsdifferenz ΔV₁ größer als die Referenzspannung wird, und die zweite Flipflop-Schaltung ihren Zustand invertiert, wenn die Eingangsspannung um eine zweite vorbestimmte Spannungsdifferenz ΔV₂ kleiner als die Referenzspannung wird, wodurch, als Funktion des Zustands der Flipflop-Schaltungen festgestellt werden kann, ob die Eingangsspannung (V₁₀) im Bereich V_R−ΔV₂ bis V_R+ΔV₁ ist oder nicht, oder ob sie höher als V_R+ΔV₁ oder niedriger als V_R−ΔV₂ ist.

2. Komparatorschaltung nach Anspruch 1, bei welcher die genannte erste Flipflop-Schaltung einen ersten Transistor (T₃) umfaßt, der ein Gate hat, das mit dem genannte zweiten Anschluß ($\overline{Q_1}$) verbunden ist, und ein zweiter Transistor (T₄) ein Gate hat, das mit dem genannten ersten Anschluß (Q₁) verbunden ist, wobei die genannte zweite Flipflop-Schaltung einen dritten Transistor (T₇) umfaßt, der eine Gate hat, das mit dem genannten vierten Anschluß ($\overline{Q_2}$) verbunden ist und ein vierter Transistor (T₈) ein Gate hat, das mit dem genannten dritten Anschluß (Q₂) verbunden ist, und die Schwellenwerte des ersten Transistors (T₃) und des vierten Transistors (T₈) so eingestellt sind, daß sie von denjenigen des genannten zweiten Transistors (T₄) und des dritten Transistors (T₇) verschieden sind.

3. Komparator nach Anspruch 1, bei welchem die genannte erste Flipflop-Schaltung einen ersten Transistor (T₃ₐ) umfaßt, der ein Gate hat, das mit dem genannten zweiten Anschluß ($\overline{Q_1}$) verbunden ist, und ein zweiter Transistor (T₄ₐ) ein Gate hat, das mit dem genannten ersten Anschluß (Q₁) verbunden ist; die genannte zweite Flipflop-Schaltung einen dritten Transistor (T₇ₐ) umfaßt, der ein Gate hat, das mit dem genannten vierten Anschluß ($\overline{Q_2}$) verbunden ist, und einen vierten Transistor (T₈ₐ), der ein Gate hat, das mit dem genannten dritten Anschluß (Q₂) verbunden ist; und ein erster und ein zweiter Kondensator (C₁, C₂) asymmetrisch mit den ersten und zweiten Flipflop-Schaltungen verbunden sind; der erste Kondensator (C₁) zwischen einem Anschluß, der einen Phasentaktimpuls (φ₁) empfängt, und einem Anschluß ($\overline{Q_1}$) der ersten Flipflop-Schaltung verbunden ist, während der zweite Kondensator (C₂) zwischen einem Anschluß, der den genannten Phasentaktimpuls (φ₁) empfängt, und dem gegenüberliegenden Anschluß (Q₂) der zweiten Flipflop-Schaltung angeschlossen ist.

**Revendications**

1. Circuit comparateur, comportant: un premier circuit bistable (FF₁) ayant une première borne (Q₁) et une seconde borne ($\overline{Q_1}$); un second circuit bistable (FF₂) ayant une troisième borne (Q₂) et une quatrième borne ($\overline{Q_2}$); un premier circuit de commutation (T₁; T₁ₐ) et un second circuit de commutation (T₅; T₅ₐ) qui connectent respectivement ladite première borne et ladite troisième borne à une source fournissant une tension d'entrée (V_C) qui doit être comparée à une tension de référence (V_R); un troisième circuit de commutation (T₂; T₂ₐ) et un quatrième circuit de commutation (T₆; T₆ₐ) qui connectent respectivement ladite seconde borne et ladite quatrième borne à une source de ladite tension de référence (V_R); et un cinquième circuit de commutation (T₁₀; T₁₀ₐ) qui est connecté en communi audit premier circuit bistable et audit second circuit bistable pour activer ledit premier et ledit second circuit bistable; le premier et le second circuits bistables ayant des tensions seuil différentes pour fonctionner de façon dissymétrique, le premier circuit bistable inversant son état quand la tension d'entrée devient supérieure à la tension de référence d'une première différence de tension prédéterminée (ΔV₁) et le second circuit bistable inversant son état quand la tension d'entrée devient inférieure à la tension de référence d'une seconde différence de tension prédéterminée (ΔV₂) de manière qu'il soit possible de déterminer si la tension d'entrée (V_C) se trouve ou non dans la plage de (V_R−ΔV₂ à V_R+ΔV₁) ou est supérieure à (V_R+ΔV₁) ou est inférieure à (V_R−ΔV₂) en fonction de l'état des circuits bistables.

2. Comparateur selon la revendication 1, dans lequel ledit premier circuit bistable comporte un premier transistor (T₃) ayant une grille qui est connectée à ladite second borne ($\overline{Q_1}$) et un second transistor (T₄) ayant une grille qui est connectée à ladite première borne (Q₁), le second circuit bistable comportant un troisième transistor (T₇) ayant une grille qui est connectée à ladite quatrième borne ($\overline{Q_2}$) et un quatrième transistor (T₈) ayant une grille qui est connectée à ladite troisième borne (Q₂), et les valeurs seuil dudit premier transistor (T₃) et dudit quatrième transistor (T₈) étant réglées de manière à être différentes de celles dudit second transistor ($t_4$) et dudit troisième transistor ($T_7$).

3. Comparateur selon la revendication 1, dans lequel ledit premier circuit bistable comporte un premier transistor ($T_{3a}$) ayant une grille qui est connectée à ladite seconde borne ($\overline{Q_1}$) et un second transistor ($T_{4a}$) ayant une grille qui est connectée à ladite première borne ($Q_1$); ledit second circuit bistable comportant un troisième transistor ($T_{7a}$) ayant une grille qui est connectée à ladite quatrième borne ($\overline{Q_2}$) et un quatrième transistor ($T_{8a}$) ayant une grille qui est connectée à ladite troisième borne ($Q_2$); et un premier et un second condensateur ($C_1$, $C_2$) qui sont connectès de façon dissymétrique au premier et au second circuit bistable; le premier condensateur ($C_1$) étant connecté entre une borne qui reçoit une impulsion d'horloge de phase ($\phi_1$) et une borne ($\overline{Q_1}$) du premier circuit bistable tandis que le second condensateur ($C_2$) est connecté entre une borne qui reçoit ladite impulsion d'horloge de phase ($\phi_1$) et la borne opposée ($Q_2$) du second circuit bistable.

*Fig. I*

*Fig. 4*

*Fig. 2A*

*Fig. 2B*

*Fig. 2C*

*Fig. 2D*

*Fig.3*

READ DATA A

LOGIC CIRCUIT

READ DATA B

TWO-BIT INFORMATION

CELL ARRAY

CELL

WORD DECODER

WORD LINE

BIT LINE

COLUMN DECODER

DATA BUS

DWL

0 116 243

*Fig. 5A*

*Fig. 5B*

*Fig.5C*

*Fig. 5D*